Europäisches Patentamt

European Patent Office

Office européen des brevets

(11) Publication number: **0 138 673**
A2

# EUROPEAN PATENT APPLICATION

(21) Application number: **84401854.9**

(22) Date of filing: **19.09.84**

(51) Int. Cl.⁴: **H 05 K 3/12**

(30) Priority: **21.09.83 US 534458**

(43) Date of publication of application: **24.04.85**
Bulletin **85/17**

(84) Designated Contracting States: **AT BE CH DE FR GB IT
LI NL SE**

(71) Applicant: **ALLIED CORPORATION, Columbia Road and
Park Avenue P.O. Box 2245R (Law Dept.), Morristown
New Jersey 07960 (US)**

(72) Inventor: **Lillie, Edwin David, 210 Edgemont Drive,
Syracuse New York 13214 (US)**
Inventor: **Ilardi, Joseph Michael, 610 Bradford Parkway,
DeWitt New York (US)**
Inventor: **Kane, Robert Peter, 203 Male Avenue,
Syracuse New York 13219 (US)**

(74) Representative: **Brullé, Jean et al, Service Brevets
Bendix 44, rue François 1er, F-75008 Paris (FR)**

(54) **Method of making a printed circuit board.**

(57) The invention is a dry method of placing electrically con-
ducting paths on a substrate and is useful in the manufacture
of a circuit board. The method is characterized by the steps of
forming a groove (21) in a substrate (20), filling the groove (21)
with an electrically conductive powder (10), applying pressure
to obtain a compacted powder (11) in the groove (21) and then
heating the compacted powder (11) to a temperature that increases the conductivity and ductility of the compacted powder and its adhesion to the substrate without adversely affecting the shape or condition of the substrate (20).

## METHOD OF MAKING A PRINTED CIRCUIT BOARD

This invention relates to printed circuit boards and more particularly to a dry additive process in the making of a circuit board.

Electrical instrumentation utilizes circuit boards for connecting together the components of its circuitry. Each circuit board is comprised of a dielectric substrate having on its surface a plurality of electrically conductive paths, arranged in a predetermined manner, to connect together circuit elements mounted to the substrate. The conductive paths may be placed on the substrate by the application of a metal conductor to the substrate and the subsequent removal of portions of the conductor by liquid chemicals or by depositing an electrical conductor on the substrate with chemical plating paths. Examples of other methods of making circuit boards may be found in U.S. Patents 4,327,124 entitled "Method for Manufacturing Printed Circuits Comprising Printing Conductive Ink on Dielectric Surface" issued April 27, 1982; and 3,013,913 entitled "Molded Printed Circuit", issued December 19, 1961. In all of the methods involving chemicals, wastes are a problem as the wastes must be disposed of without adversely affecting our environment. Further, the methods using chemicals are expensive and relatively complex so that only a few companies are capable of producing printed circuit boards using these methods. In the methods that apply heat and pressure to a metallic powder and moldable substrate the resulting metal conductor material from the substrate dispersed within the conductor resulting in a conductor that does not have the conductivity necessary for certain circuit board applications.

## Disclosure of the Invention

This invention is a method for placing electrically conducting paths on a substrate by a dry process which eliminates liquid chemical wastes and which greatly simplifies the manufacturing process for making a circuit board. The invention is characterized by the steps of forming a groove into a substrate, filling the groove in the substrate with an electrically conductive powder, applying pressure to compact the powder in the groove of the substrate, and then heating the substrate to a temperature that increases the conductivity and ductility of the compacted powder and its adhesion to the substrate without adversely affecting the shape or condition of the substrate.

Accordingly, it is an advantage of this invention to provide a simple dry method of placing conductive paths on a substrate that is useful in the manufacture of a circuit board.

An advantage of the method is that it does not result in large quantities of liquid chemical wastes which if not treated properly would provide a hazard to our environment.

Another advantage of the method is that it reduces the complexity and expense of manufacturing a circuit board.

## Detailed Description of the Invention

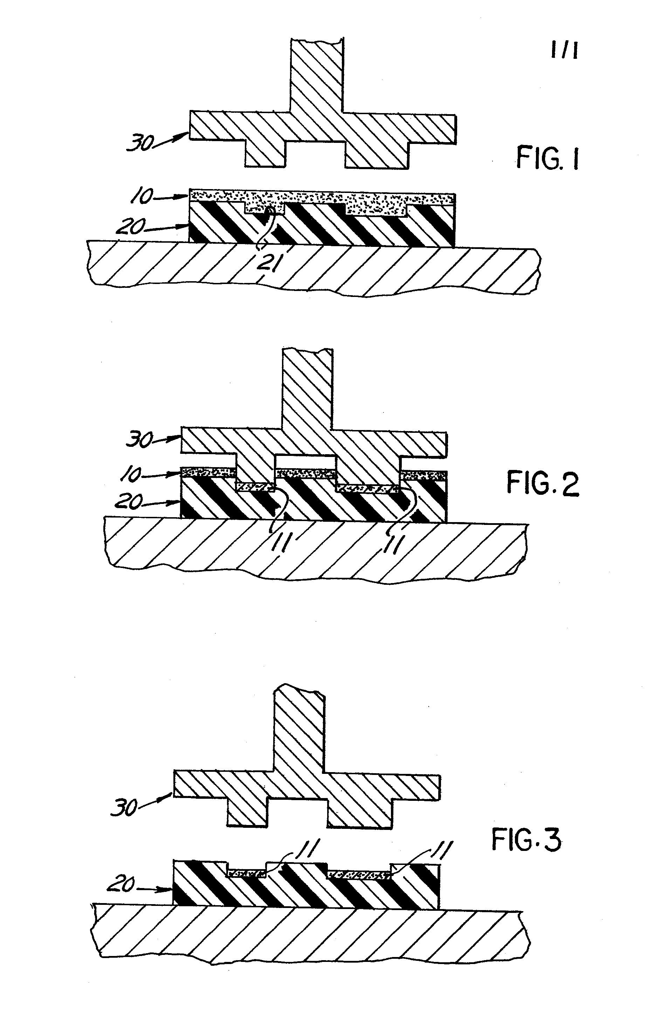

FIGURES 1-3 illustrate the application of pressure by a die 30 to an electrically conductive powder 10 in the groove 21 of a substrate 20 to provide a compacted powder 11 in the groove 21.

The following are the steps of the method that incorporate the principles of this invention.

Step 1 is the forming of at least one groove 21 into a substrate 20. The groove 21 may be any predetermined pattern and may be made by injection molding a substrate, or by stamping the substrate with a die. A preferable material for such a substrate would be a plastic such as polyetherimide. Other dielectric materials such as glass filled plastic or a ceramic may be used. Preferably a polyetherimide substrate 20 is stamped with a metal die 30 to make a groove 21.

Step 2 is the filling of the groove 21 in the substrate 20 with an electrically conductive powder 10. The electrically conductive powder 10 may be a metal or metal alloy such as a copper electrolytic dust which has a particle size less than about 100 microns and is a flaky irregularly shaped particle. Preferably, the longest dimension of any particle is about 1/10 the width of the groove.

Step 3 is the application of pressure by a die 30 to compact the electrically conductive powder in the groove 21 in the substrate as illustrated in FIGURE 2. When a die 30 is used for making the groove 21 in the substrate it is preferably shaped to make a groove 21 having a rectangular or square cross section. This then allows the same die 30 to be used to compact the conductive powder the groove. Compacting the powder in the groove 21 is accomplished by first spreading the metal powder 10 over the substrate in a manner that fills or over fills the groove 21. A die 30 is then used to apply pressure between the substrate 20 and the powder 10 in the groove 21 to obtain a compacted powder 11 as shown in FIGURES 2 and 3. Spreading additional powder and compacting it may be accomplished if a thicker compacted powder 11 is desired. The pressure applied may vary depending upon the materials chosen for the conductive powder 10 and the substrate 20. Preferably, the pressure applied is the highest pressure possible that can be applied to the electrically conductive powder without adversely affecting the substrate. Such adverse effects would include fracturing of the substrate 20 or the bending or warping of the substrate so that it is not acceptable for use as a circuit board. When a plastic substrate and a copper electrolytic dust are used a pressure of about 20,000 to 55,000 psi (2.9 to 8.0 Pascals) at room temperature will achieve the desired result. Such a pressure range is sufficient to cold work the metal particles of the powder to increase the bulk density of the resulting compacted particles. In the preferred embodiment the compacted powder 11 is recessed within the grooves to protect the compacted powder from being fractured during handling. Alternatively, pressure may be applied to the powder and the substrate without using a die. This is accomplished by placing a deformable material such as a plastic, e.g., Delrin, over the powder and then applying pressure to deform the plastic into the groove.

Step 4 is the heating of the compacted powder 11 in the groove. Depending on the conductive powder and substrate material used, the temperature should be sufficient to increase the conductivity and ductility of the powder 11 and its adhesion to the substrate 20 without adversely affecting the substrate, e.g., warping, bending or cracking. Preferably, the compacted powder is heated to a temperature at about its isothermal annealing temperature for a period of 20 to 60 minutes. For a copper electrolytic dust this temperature is about 200 degrees centigrade. This temperature is acceptable when the substrate material is a plastic such as polyetherimide and prevents the dispersion of the substrate material into the final conductive path except at the interface between the conductive path and substrate. The heating step may be accomplished in an oven or with a heated die.

In some instances where a powdered metal 10 such as tin is used to make a conductive path, applying pressure to compact the tin is sufficient to provide the conductive path without the need to heat the compacted powder 11. For tin a pressure above 10,000 psi (1.45 Pascals) will be sufficient to compact the powder.

Having described the invention what is claimed is:

1. A method of placing electrically conductive paths on a substrate, comprising the steps of:
   forming a groove into a substrate;
   filling the groove in the substrate with an electrically conductive powder;
   applying pressure to compact the powder in the groove in the substrate; and
   heating the compacted powder in the groove.

2. The method as described in Claim 1 wherein the step of heating the substrate with a compacted powder in the groove comprises: heating the compacted powder to about its isothermal annealing temperature.

3. The method as described in Claim 1 wherein the step of applying pressure to compact the powder in the groove in the substrate comprises: applying the highest pressure possible to the powder and substrate without adversely affecting the substrate.

4. The method as described in Claim 1 wherein the pressure applied is about 20,000 to 55,000 psi (2.9 to 8.0 Pascals) at room temperature.

5. The method as described in Claim 2 wherein the step of forming a groove into a substrate comprises: stamping a plastic substrate with a die to form a groove into the substrate.

6. The method as described in Claim 1 wherein the steps 2 of applying pressure to compact the powder in the groove in the substrate comprises: placing a deformable material over the groove in the substrate and then applying pressure to compace the powder in the groove.

7. The method as described in Claim 3 wherein a die is used to compact the powder in the groove.

8. A method of making a circuit board comprising the steps of:
   forming a groove into a substrate;
   filling the groove in the substrate with an electrically conductive metal powder;

applying pressure sufficient to increase the bulk density of the powder in the grooves in the substrate; and

heating the compacted powder in the groove to about the isothermal annealing temperature of the powder.

9. The method as described in Claim 8 wherein the electrically conductive powder is a copper electrolytic dust and the temperature to which the compacted powder is heated is of about 200 degrees centigrade for a period of 20 to 60 minutes.

10. A method of placing electrically conductive paths on a substrate, comprising the steps of:

forming a groove into a substrate;

filling the groove in the substrate with an electrically conductive powder; and

applying pressure to compact the powder in the groove in the substrate.

30

FIG. 1

10

20

21

30

10

20

FIG. 2

11    11

30

FIG. 3

11    11

20